# EUROPEAN PATENT SPECIFICATION

(11) **EP 3 270 584 B1**
(45) Date of publication and mention of the grant of the patent: **02.09.2020**
(21) Application number: 17179350.8
(22) Date of filing: 03.07.2017
(51) Int. Cl.: H04N 5/44, H04N 21/426, H04N 7/10, H04N 7/20

(54) **GALVANIC ISOLATED DEVICE AND CORRESPONDING METHOD AND SYSTEM**
GALVANISCH ISOLIERTE VORRICHTUNG UND ENTSPRECHENDES VERFAHREN UND SYSTEM
DISPOSITIF ISOLÉ GALVANIQUE ET PROCÉDÉ ET SYSTÈME CORRESPONDANTS

(30) Priority: 12.07.2016 EP 16305900; 11.08.2016 EP 16183670
(43) Date of publication of application: 17.01.2018
(73) Proprietor: InterDigital CE Patent Holdings, 75017 Paris (FR)
(72) Inventor: FOUQUE, Claude, 35576 Cesson-Sévigné (FR); SALOU, Frédérique, 35576 Cesson-Sévigné (FR); MARCHAND, Philippe, 35576 Cesson-Sévigné (FR); GUITTON, Xavier, 35576 Cesson-Sévigné (FR); LEPOIL, Philippe, 35576 Cesson-Sévigné (FR)
(74) Representative: Tarquis-Guillou, Anne

(56) References cited:
- WO-A1-97/26762
- US-A- 5 436 675
- US-A1- 2009 167 465
- VISION PRODUCTS EUROPE LTD: "V5-025 Galvanic Isolator for IRS and MATV System; Safety Galvanic Isolator for interconnecting buildings/dwellings", INTERNET CITATION, September 2009 (2009-09), page 1, XP002729706, Retrieved from the Internet: URL:http://www.vision-products.co.uk/app/u ploads/product_files/479/v5-025_galvanic_i solator.pdf [retrieved on 2014-09-15]

## Description

### 1. Field of the present disclosure.

The present disclosure relates to the field of electronic devices adapted to be interconnected with other electronic devices.

A galvanic isolated device and corresponding method and system are described.

### 2. Background Art.

Home electronic devices are categorized into several Classes. These Classes correspond to a set of electrical and/or mechanical characteristics. One of these characteristics which is taken into consideration in defining the Class of an item of equipment is the presence or absence of an earth ground of the mains network of the device concerned, the connection being made by a ground conductor.

There is a need to provide a home electrical device being safer and more adaptable than some solutions of the prior art.

### 3. Summary of the present disclosure.

The present principles enable at least one of the above disadvantages to be resolved by proposing an electronic device, and corresponding method and electronic system, according to the appended claims. Not all embodiments fall under the claims

The electronic device can notably comprise a wired communication interface for the reception of an electrical signal, the communication interface comprising a connector suitable for the connection of a cable and at least one electronic interfacing circuit for transmitting an electrical signal.

Depending upon embodiments, the cable can be adapted to receive and/or transmit different kind of data, like RF carrier with different modulations and/or DC voltage.

By "radio frequency" (RF) signals is understood, in the paragraphs which follow, signals (like signals of high frequency) having at least one frequency supported and used in a cable transmission system.

For instance, the cable can be adapted to receive and/or transmit audiovisual signal, or telecommunication signal, representing high data rate, like data received from a network compatible with the Data Over Cable Service Interface Specification (DOCSIS) standard. In some embodiments, the electrical signal can comprise multiplexed signals comprising different types of data, like data with different formats (for instance audiovisual data, and/or telecommunication data (like voice, data compatible with an internet protocol (IP), and/or control data)).

### 4. Brief description of Drawings.

The present disclosure will be better understood, and other specific features and advantages will emerge upon reading the following description, the description making reference to the annexed drawings wherein:
- Figure 1A shows an installation comprising a cable digital television receiver-decoder device connected to a television set
- Figure 1B shows the installation of figure 1A in the presence of an induced current loop according to the prior art.
- Figure 2A shows an electronic device according to a first embodiment of the present disclosure.
- Figure 2B shows an electronic device according to a second embodiment of the present disclosure.
- Figure 2C shows an electronic device according to a third embodiment of the present disclosure.
- Figure 2D shows an electronic device according to a fourth embodiment of the present disclosure;
- Figure 3 illustrates a method for processing an electrical signal according to at least one embodiment of the present disclosure.

It is to be noted the annexed drawings figures have only an exemplary purpose. Notably, in all figures, the modules shown are functional units that may or may not correspond to physically distinguishable units. For example, these modules or some of them are grouped together in a single component, or constituted of functions of the same software. On the contrary, according to other embodiments, some modules are composed of separate physical entities.

### 5. Description of embodiments.

In a general but non-restrictive way, the present disclosure relates to an electronic device (like a STB). Notably, the electronic device can be adapted to be integrated into an electrical installation suitable for supplying electrical power thereto and for supplying power to at least one other device (for instance a TV set), the two devices being connected to the electrical power supply network, one via the intermediary of a power cord comprising a ground conductor, the other via the intermediary of a power cord without a ground conductor. The disparities in earth grounds between the two devices can be such that, according to characteristics of the electrical installation and interconnection conditions of the devices, induced current loops may arise without adapted isolation.

The two devices can for instance belong to different Classes.

Classes 1 and 2, for example, are respectively described in standards document paragraphs IEC 61140 2001, 7-2 3rd Edition and IEC61140 2001, 7-3 3rd Edition.

Class 1 devices are connected to the mains network with a ground conductor (designed with 3rd earth pin connection). Class 2 devices have no circuit connected to earth. Some electronic devices for home use are electrical Class 1 while some other electronic devices are Class 2 device. For instance, some TV sets with Flat screens technology are Class 1 device. STB or DVD player can be example of Class 2 equipment. TV set and STB are often interconnected at an end user installation (like home network) by cable. For instance, a video signal can be provided by the STB to the TV set through a High-Definition Multimedia Interface (HDMI) or through an analog interface like a peritelevision cable (also known as peritel cable or SCART cable (where SCART stand for the French label "Syndicat des Constructeurs d'Appareils Radiorecepteurs et Téléviseurs") or a composite audio and/or video cable (also known as Chroma Video Blanking Synchro (CVBS) cable). When the STB and the TV screen are interconnected, the STB has its grounding (reference) connected to TV set ground and so to the end-user earth reference.

The interconnection of two devices of different electric Classes, by a wired connection, can make possible an occurrence of current loops according to other parameters of the installations (like Main AC power distribution topology).

In fact, according to the characteristics of the installations constituted by the different elements for supplying, connecting and transporting signals and according to the characteristics of the interconnected devices, problems, disturbances or degradations may arise.

More specifically, due to existing disparities in the quality of electrical connections to earth, and any connections of the neutral connector to earth, noticeable disparities in electrical voltages may be created at points of the installation which are theoretically to be at identical electrical voltages. These disparities in electrical voltages result in induced current loops. These induced currents cross the devices and can in certain cases degrade or destroy circuits or elements when the devices are interconnected together. It is possible, for example, between a television receiver-decoder device categorized in electrical Class 1 and a television set categorized in electrical Class 2, to see High Definition Multimedia Interface (HDMI) connection cables partially or completely burnt and the associated interfaces destroyed or rendered inoperative.

Indeed, in an end user installation, a STB is usually interconnected to the Radio Frequency (RF) distribution system (for instance cable distribution, or terrestrial distribution like Single Master Antenna Television (SMATV)) which delivers the RF signal to be demodulated and decoded by the STB. Equipments of the RF distribution system (like Cable Modem Termination system (CMTS) for Cable network or SMATV) can have different locations, being either close to the end user installation or quite far from him. The earth ground of a RF distribution equipment can be different from the earth ground of the end user installation (house, apartment...) and also different with the AC main power distribution. With some main power distribution configuration (like Terre Neutre Commun Separated (TNC-S), Terre Neutre Commum (TN-C) or Low-voltage distribution like Terra-Terra (TT) distribution), a voltage difference between the different earth grounds of the system can take place. This configuration creates a faulty condition in the system called "balancing current circulation" that can lead to a damage to the electronic device (STB, TV set, DVD player...) or even to a risk of fire in the end user house.

One possible way to address this issue is to add a galvanic isolator in order to avoid current loops. Indeed, a galvanic isolator can ensure full galvanic isolation, as both signal and groundings paths are completely separated from each side. Notably, it is recommended to install a galvanic isolator at the input of a building network. Unfortunately, this recommendation is not taken into account by the operators and a galvanic isolator is often not implemented.

Adding a removable galvanic isolator to a STB can raise some issue in a safety point of view, if the galvanic isolator is plugged in presence of power by an unexperienced end-user. For instance, the end user can touch both sides of the component. If there is a voltage difference on the sides on the component, an electrical shock for the end user can occur.

Another possible solution consists in equipping a device with an integrated (thus not removable) galvanic isolator. However, such a solution has the drawback of preventing the device to be used for supplying DC power to another equipment Such a solution can prevent, notably, a STB to supply DC power to a digital Low Noise Bloc (LNB) of a receptor of a Satellite Antenna.

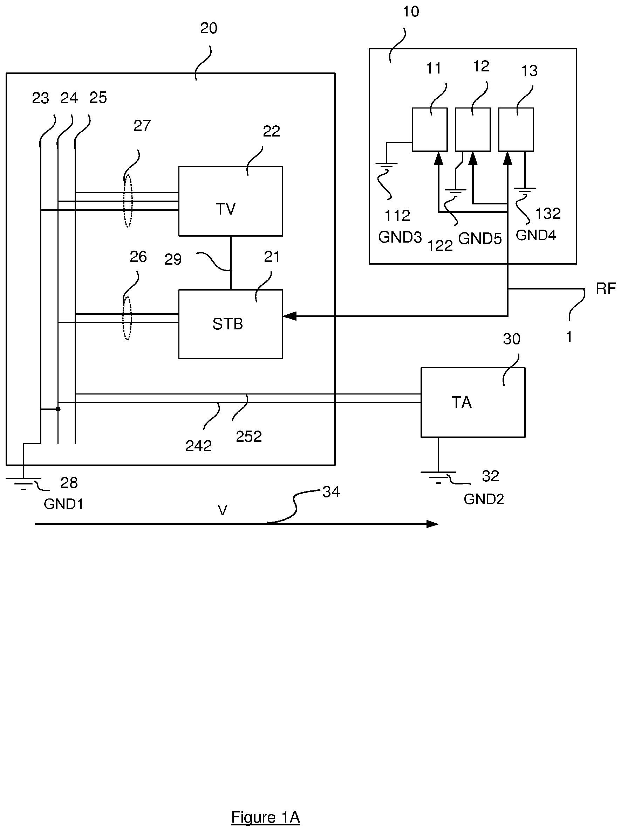

**Figure 1A** shows a complete installation enabling the supply of power to and the operation of electronic devices such as a cable television receiver-decoder device STB 21 and a television set TV 22. The receiver-decoder device STB 21 is connected to a cable RF 1 for receiving radio frequency signals by cable from a cable head-end not shown. Receiver-decoder STB 21 is connected to the electrical power supply network, also called the mains network or mains P, N, L via the intermediary of a power cord 26 suitable for supplying power to Class 2 (electrical Class 2) devices. Network P, N, L comprises a phase conductor L 25, a neutral conductor N 24 and a protective conductor P 23; the conductors 24 and 23 being connected. Television set TV 22 is connected to the mains network via the intermediary of a power cord 27 suitable for the supply of power to Class 1 devices (electrical Class 1). The two devices (or items of equipment) are used in a same dwelling, in a house 20 whose mains network P, N L is connected to earth by an earth ground GND1 28. The earth ground element can be a stake made of conductive material, a wire mesh or any other element designed for connecting ground conductors of electrical installations to earth. The electrical network of house 20 is supplied with power by a power supply transformer TA 30, serving the network of house 20 via the intermediary of the phase conductor 252 and neutral conductor 242. The set of ground conductors of the local power supply transformer TA 30 are connected to earth by an earth ground GND2 32 similar to earth ground GND1 28, in terms of function. According to the type of elements used for the earth ground (stake or mesh, for example), their characteristics (their dimensions or their wear state, for example) and the nature of the ground, disparities exist in terms of contact resistance and therefore in terms of equivalent earthing (or ground) resistance. Thus, differences in potentials may arise between two earth ground elements, such as, for example, GND1 28 and GND 2 32 and result in the presence of voltages such that the voltage V 34 shown is equal to the difference between potentials GND2 32 and GND1 28. These voltages arise from current variations around the earth ground elements, notably due to events and modifications on the electrical installation (starting, switching and stopping operations, etc.).

The overall installation of figure 1A further comprises a building 10 next to dwelling house 20. In this building 10, items of equipment or devices 11, 12 and 13 are used, respectively connected to earth by earth grounds GND3 112, GND5 122 and GND4 132. Items of equipment 11, 12 and 13 in building 10 are, for example, cable digital television decoder-receivers, suitable for receiving audiovisual programs received from cable RF 1 which also supplies receiver-decoder STB 21 of house 20 with radio frequency signals encoding the audiovisual programs. Cable RF 1 therefore constitutes an equipotential common to the installations of building B and of house 20.

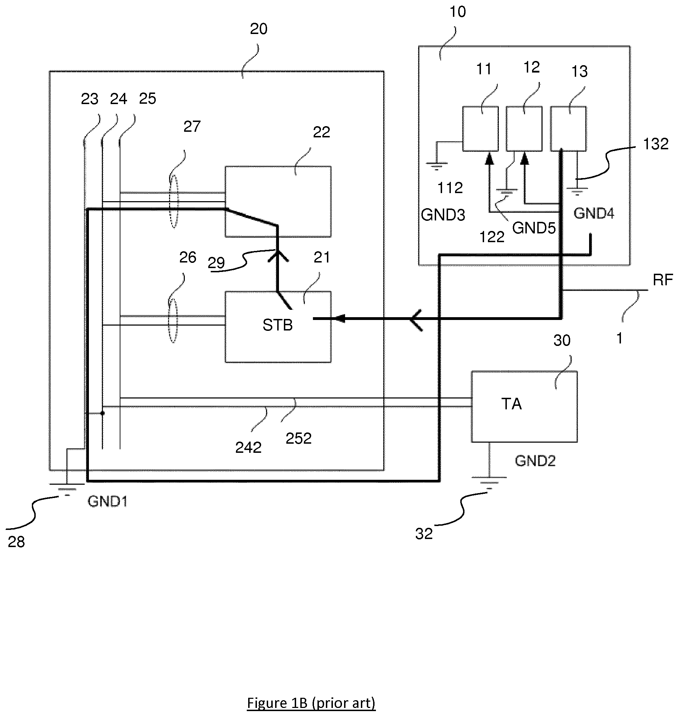

**Figure 1B** shows the installation shown in figure 1A, in a case where the STB device is not galvanically isolated (like in some prior art solutions), in the presence of an example of induced current loop. Figure 1B shows the presence of the current loop between building 10 and house 20. There is no galvanic isolation enabling avoidance of the occurrence of a current loop. The current loop is shown by a bold line in figure 1B. It traverses a path running from item of equipment 13 to receiver-decoder STB 21, then via HDMI link 29, to television set TV 22 connected to network P 23, N 24, L 25 by power cord27. The current loop therefore finds a path via devices STB 21 and TV 22 and particularly via a connection cable 29 (HDMI cable) which thus sometimes acts as a fuse between the two items of equipment when there is a difference in potential between a ground point in building 10 and the ground point of house 20 and when receiver-decoder STB 21 is not equipped according to the concept of the present disclosure. An example of conditions resulting in unpredictable variations in earth ground potentials is the undesirable variations in current consumption in the circuits of the electrical network of building 10. The sudden switching operations of home equipment results in variations in electrical consumption such that the current fluctuations conducted to earth vary the electrical potentials at the earth ground elements (specific to the grounds GND3 112, GND4 132 and GND5 122). The items of equipment with high consumption and whose activation and deactivation are liable to result in significant current variations at the earth ground elements are for example washing machines, cooking and heating equipment or lift motors.

It should however be noted that the induced current loop problems may arise in other neutral point arrangements, that is to say whether the neutral conductor 24 is connected to the protective conductor 23 (and therefore to earth) or not.

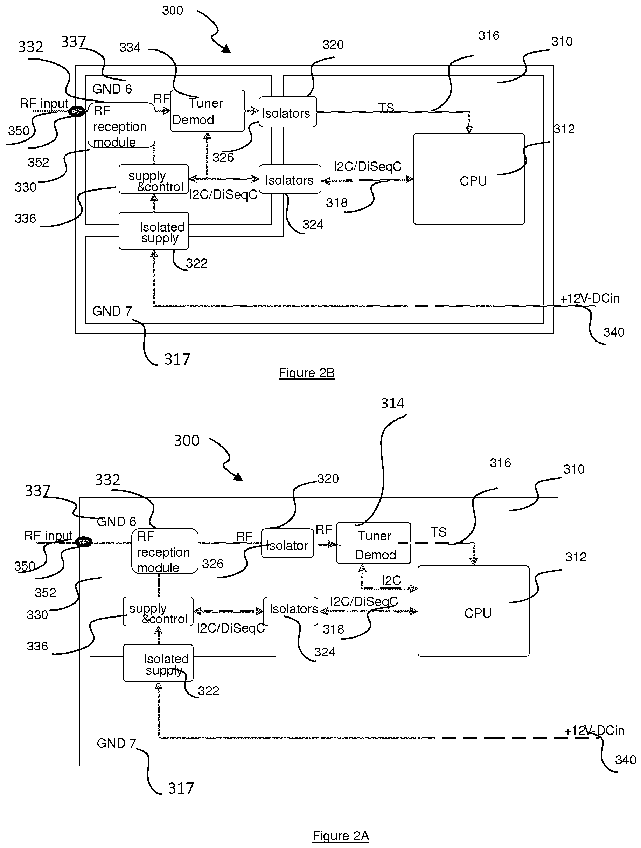

**Figures 2A to 2D** show a decoder-receiver STB 300 according to different embodiments of the present disclosure. The STB is adapted to receive RF signals (like audiovisual programs or DOCSIS data) over a cable network via at least one cable 350.The STB is also adapted to transmit DC current by the way of the same cable 350. For instance, the STB can supply Direct Current via the cable to a LNB of a receiver of a satellite antenna.

In the detailed embodiments, the STB comprises at least one embedded galvanic isolator 324, 326 with the capability to deliver on at least one RF connector 352 of the STB a remote voltage (and control signals if necessary) to an external device (like single LNB, digital LNB, active antenna with amplifier for instance). Such an embodiment can permit to the same STB to be adapted to be used in a collective installation (cable, SMATV or equivalent) or to an individual installation (like dish with LNB, external active antenna with amplifier...).

According to figures 2A to 2B, the STB comprises two separate grounding areas 310, 330 linked together by one or several galvanic isolation modules 324, 326 and by at least one isolated supply module 322 (for instance an isolated supply having a DC/DC fly back topology).

The isolated supply can vary upon embodiments and notably according to the needed power to be output by the electric device. Depending upon embodiments, the isolated supply can be adapted to provide a large range of power, for instance in the order of 0 to several tens of watts (for instance 350 mA with a voltage of 18V, 450 mA with a voltage of 18V, 1 Watt, 10 Wat, 15 Watt, 18 Watt, 25 Watt, 36 Watts...).

The first ground area, also called herein "front-end area", "front-end component", "front-end unit" or "front-end module", comprises at least one front-end connector 352 suitable for the connection of the cable 350 and at least one control and/or supply module, like a controller 336, which is adapted to supply DC power, and in some embodiments control signals, via the front-end connector and the cable 350, to a LNB module of a reception module of an antenna (like a satellite antenna).

A second grounding area 310, also called herein "back-end area", "back-end component", "back-end unit" or "back-end module", embed a Control and Processing Unit (CPU) 312 and is connected to a DC power line 340. All details of the back-end module are not illustrated in figures 2A to 2D, as their description is not considered as useful to the understanding of the present disclosure for the one skilled in the art. The back-end module can comprise, amongst others, a CPU module and a volatile memory, a non-volatile memory, a de-multiplexer, a decoder, a display memory and interface circuits for outputting to a reproduction device (like a TV set or instance). The CPU can notably manage the control module 336 of the front-end module by means of controls and/or communication signals (like signals of type GPIO, I2C bus, Reset, controls signals like signals compatible with Digital Satellite Equipment Control (DiSEqC) standard) send through the galvanic isolated module (for instance through an opto-coupler component of the galvanic isolated module). The STB can also comprise a User Interface (like screen, buttons, ...)

The presence of the galvanic isolation modules 324, 326 between the first and second ground area can help to prevent DC signal continuity and connection between the ground GND6 337 of the front-end area to the ground GND7 317 of the back-end area as thus to prevent current loops, as already explained.

The isolated supply module 322 receives DC power via the second grounding area 330 from an input voltage line (for instance a voltage line belonging to an interval of [2 V; 30V] like 3V, 5V, 12V, 18V, 19V, 25V...) 340 and supply DC voltage to at least some module of the front-end area 310.

The RF receiving path of the STB is secured by the presence of the galvanic isolation module(s) and the galvanic isolation modules are not used in the Direct Current supplying path between the DC power line 340 and the cable 350 and thus do not prevent the supply of DC power by the STB.

At least some embodiments of the present disclosure can thus permit to provide an STB adapted to operate in at least two different modes (RF reception with or without DC (and/or control) supplying), depending for instance on the type and/or the role of the cable connected to the STB.

The galvanic isolator module can vary upon embodiments. For instance, at least one of the galvanic isolator module(s) can comprise a transformer with windings, the signals input by the front-end module to a first winding of the transformer being transmitting by magnetic coupling to a second winding of the transformer and then output to the back-end module.

In some embodiments, at least one of the galvanic isolator module(s) can comprise capacitors enabling the transmission of high-frequency signals and having an infinite DC impedance. A first capacitor can be used to link the signals coding the audiovisual programs contained in the RF signal received over the cable 350, a second capacitor can be used for the small signal earth ground.
In some embodiments, at least one of the galvanic isolator module(s) can comprise an optical device like an opto-coupler.

Depending upon embodiments, when the STB comprises at least two galvanic isolator modules, the galvanic isolator modules can be identical or different.

Advantageously, integrating a galvanic isolation device into the STB makes it possible to reduce the overall cost of the installation protected against the occurrence of current loops and makes it possible to avoid the risk of damage to equipment.

In the embodiment illustrated by figure 2A, the front-end area also comprises a RF reception and filtering module 332 (or RF receiver), which is adapted to receive RF signals, via the front-end connector 352. The RF reception module 332 can output RF signals to a galvanic isolator module 326. At least some embodiment where the isolating between the front-end area and the back-end area is performed at the RF stage can be adapted to situation where major integration constraint and/or major cost constraint are encountered.

In the embodiment illustrated by figure 2B, the front-end area 310 also comprises a Tuning and demodulating Module 334 (like a tuner and/or a demodulator) which receive RF signals output by the RF reception module 332. In turn, the Tuning and demodulating module 334 transforms the RF signal received in a Transport Stream (TS) signal that is output to the galvanic isolator module 326. At least some embodiment where the isolating between the front-end area and the back-end area is performed at the TS stage (and thus where the signal input to galvanic isolator module are digital signal, rather than RF signals) can permit to have a device more robust to noise phenomena.

In some embodiments, like the illustrated embodiments, the RF reception module and the tuning and/or demodulating module are separate units or entities. In other embodiments, where the front-end module comprises a tuning and/or demodulating module, the RF reception module can be integrated in the tuning and /or demodulating module.

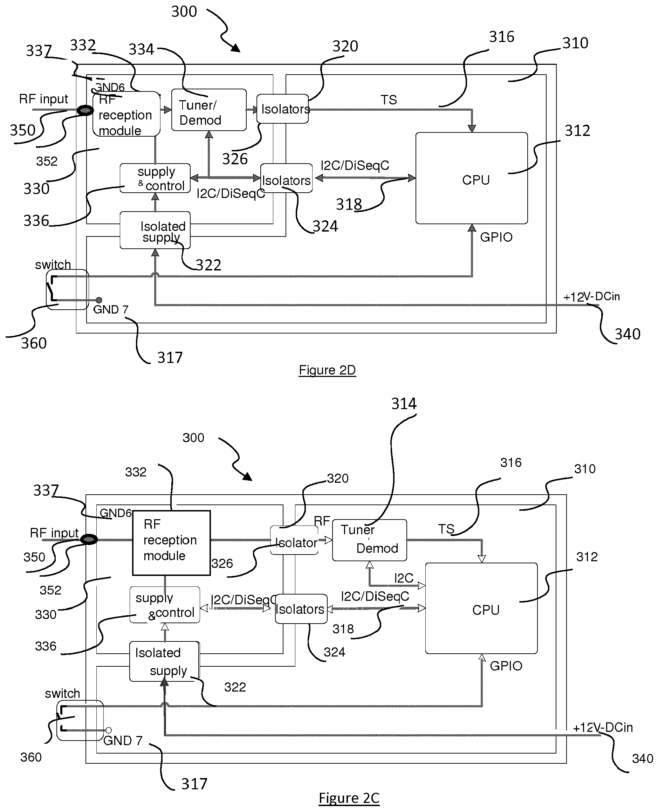

In the embodiments illustrated by figures 2A, 2B, 2C and 2D, the STB can be configured in one or the other mode (RF reception with or without DC (and/or control) supplying). The configured mode can notably depend of the type of network to which the STB is linked via the cable 350. Indeed, when the STB is linked via the cable to a collective installation (cable, SMATV or equivalent) (for instance when the STB is installed in a building), DC supplying may not be necessary. At the opposite, when the STB is installed in a house, or other kind of individual installation (like dish with LNB, external active antenna with amplifier...) DC supplying may be required.

In the embodiments illustrated by figures 2A or 2B, the STB can be configured in one or the other mode, via a User interface of the STB, notably by interacting with a user via a display with a software interface or via a remote-control device (like an infra-red remote-control device). In such embodiments, no hardware manipulation of the STB itself is needed (as with a manual switch for instance) for switching between the different modes and thus associated safety risks are avoided. Indeed, some solution based on the presence of hardware commutation mean (other than the switch 360 of the present disclosure) that by-pass the galvanic isolation module by direct connection between the grounds of the front and back-end module, manually actuated, can lead to situations where the STB is switched on a mode that is inconsistent with the role of the cable 350 or where some safety risks appears transiently during the switching (like inter-connection of the earth grounding of different systems).

The command of the control module can be performed from the CPU of the back-end module (after receiving a request from the User Interface for instance). The commutation command can be included in General Purpose Input/ Output (GPIO) signals received by the control module through an opto-coupler of the galvanic isolating module. The opto-coupler buffers the mode (or in other words stores the switch state) from the back-end area to the front-end area.

In such an embodiment, the mode of the STB can be stored of a persistent memory of the STB.

The embodiment illustrated by figure 2C is similar to the embodiment illustrated in figure 2A except that a switch 360 is added to the STB 300. The switch 360 can be accessible from the outside of the STB and can be adapted to commute the STB between the different modes (RF reception with or without DC (and/or control) supplying). For instance, it can be manually actuated. Such an embodiment can be used in a STB with no user interface or a user interface with limited functionalities. It can be adapted for instance to installation where the STB is configured by a technician or even by the end user itself, as the switch only controls the GPIO and does not connect both ground (thus the actuation of the switch 360 do not lead to safety risks).

The switch 360 can be an elementary switch, like a micro-switch, adapted to control a logical state of a command signal. It does not need to be a power switch.

In the embodiment illustrated by figure 2C, the actuation of the switch controls the commutation of an electrical command signal, in voltage, which can take at least two logical values (like 0 or 1). The commutation of the command signal can be further detected by the CPU 312 of the back-end area 310 for instance, and used for controlling the transmission of control signal (like i2C signal for instance) to the supply and/or control module 336 of the front-end area 330 and/or for managing the isolated supply 322, thus permitting an interaction of the back-end area 310 with the front-end area 330, the supplying of direct current and/or the transmission of control signal to the cable.

In another embodiment, not illustrated, the command signal can be conveyed from the switch 360 to the front-end area 330 thanks to a galvanic isolator and analyzed in a microprocessor of the front-end area in order to pilot the isolated supply 322 according to the command signal.

The embodiment illustrated by figure 2D is similar to the embodiment illustrated in figure 2B except that the mode of the STB is controlled by an external switch 360 as already explained in link with figure 2C.

In at least one embodiment, the front-end connector can be accessible from a rear panel of the STB, made for instance at least partially of non-conductive (isolating) material such as plastic,

In some embodiments, where the rear panel is in plastic and also comprise other connectors (like HDMI or Universal Serial Bus (USB) connectors), the metallic parts of the other connectors can be hidden inside the rear panel, in order to prevent hazardous voltage risk due to the galvanic isolator configuration.

The present disclosure is not limited to the embodiments described above but also applies to any device enabling the reception of electrical signals received by cable and comprising galvanic isolation means configured to prevent the occurrence of induced current loops when two devices respectively connected to earth and not connected to earth are interconnected by a wired link.

Notably, depending upon embodiments of the present disclosure, the electronic device can comprise one, two or several front-end connector(s) (each providing RF signal to a galvanically isolated communication path), one, two or several isolated supply module(s), and/or one, two or several front-end control module(s). Furthermore, each control module can provide DC current through one, two or several front-end connectors. For instance, a front-end control module can comprise several LNB module, or dual LNB modules.

The embodiments detailed above describe embodiments of the present disclosure implemented in an item of equipment of cable digital television receiver-decoder type. However, the present disclosure does not apply solely to this type of equipment but to any device comprising an interface for connecting by wired link to another item of equipment, the device being configured to operate in an electrical environment where items of equipment of different electrical Classes coexist and comprising for certain items an earth ground element and being, for others, without earth ground element.

The present disclosure also applies, for example, to a desktop computer, a laptop computer, a tablet, a television set, a hi-fi system or a gateway for accessing a broadband communication network.

The electrical signal can be an audiovisual signal, or a telecommunication signal, representing high data rate, like data received from a network compatible with the Data Over Cable Service Interface Specification (DOCSIS) standard. It can comprise multiplexed signals comprising different types of data, like data with different formats (for instance audiovisual data, and/or telecommunication data (like voice, data compatible with an internet protocol (IP), control data)).

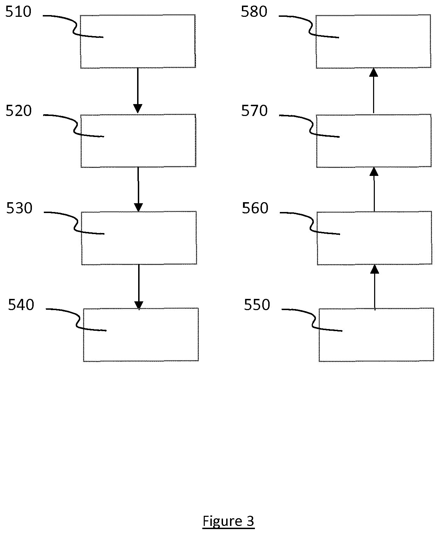

**Figure 3** illustrates a method for processing an electrical signal according to at least one embodiment of the present disclosure. Depending upon embodiments, the method can be implemented for instance in an electronic device as the electronic device 300 illustrated by figure 2A, 2B, 2C or 2D.

According to the illustrated embodiment, the method comprises:
- receiving 510 at least one electrical signal on at least one front-end connector of the electronic device 300, the front-end connector being adapted to be connected to a cable 350;
- transmitting 520 the received electrical signal through at least one communication path including at least one isolation module 324, 326 to at least one processing module 312 of the electronic device 300;
- processing said electrical signal;
- providing said processed electrical signal to said second electronic device via said wired link.

In the particular embodiment of figure 3, where the cable 350 is adapted to transmit Direct Current, the method can comprise:
- receiving 550 Direct Current from a Direct Current line;
- transmitting 560 said received Direct Current through a Direct Current supplying path not using the isolation module(s) 324, 326, to at least one control module 336 of the electronic device 300;
- supplying Direct Current to said front-end connector 352.

## Claims

1. An electronic device (300) comprising:
- a front-end module (330) comprising:
• at least one front-end connector (352) adapted to be connected to a cable external to said electronic device for receiving at least one radiofrequency signal and for transmitting Direct Current,
• a reception module (332) adapted to receive said at least one radiofrequency signal from said front-end connector (352);
- a Tuning and demodulating Module (334) adapted to receive said at least one radiofrequency signal from said reception module; and to transform said at least one radiofrequency signal in at least one Transport Stream signal
- an interfacing module (320 322 324 326) comprising at least an isolation module adapted to galvanically isolate said front end module and a back-end module < (310) of said electronic device, and to transmit, to said back-end module (310) of said electronic device, at least one digital signal received from said front-end module (330);
said interfacing module comprising at least one isolated DC current supplying module, adapted to be connected to said back-end module and to transmit Direct Current to at least one control module of said front end module,
- said back-end module comprising a control processing unit (312) adapted to transmit at least one command signal to said control module (336) of said front end module (330), said control processing unit being adapted to operate in a first mode, where said control module (336) of said front-end module (330) supplies Direct Current to said front-end connector (352) in response to said command signal, and in a second mode, where no Direct Current is supplied by said control module (336) of said front-end module (330) to said front-end connector (352) in response to said command signal;
said Transport stream signal output by said tuning and demodulating module ; (334) is provided through said galvanic isolator module (320 326) to said control processing Unit.

2. The electronic device (300) according to claim 1, wherein said control processing unit (312) is adapted to be commuted between said first mode and said second mode, or vice-versa, via a user interface of said electronic device.

3. The electronic device (300) according to claim 1 or 2, wherein said isolation module is adapted to prevent a Direct Current signal continuity and/or a connection of earth ground of said front-end and back-end modules.

4. The electronic device (300) of any of claims 1 to 3, wherein:
- said back-end module comprises at least one back-end connection module adapted to receive Direct Current from a Direct Current line; and
- said interfacing module comprises at least one isolated DC current supplying module, adapted to be connected to said back-end connection module and to transmit Direct Current to said control module (336).

5. The electronic device (300) of any of claims 1 to 4, wherein said control module is adapted to transmit at least one control signal to said front-end connector (352).

6. The electronic device (300) of any of claims 1 to 5, wherein said user interface comprises a switch adapted to command said control module via said control processing unit (312).

7. The electronic device (300) of claim 6, wherein said switch is accessible at least partially from an outer casing of the electronic device.

8. The electronic device (300) of claim 6 or 7, wherein said switch is adapted to be manually actuated.

9. The electronic device (300) any of claims 1 to 8 wherein said electronic device comprises a persistent memory adapted to store whether said control processing unit (312) is in said first mode or said second mode.

## Patentansprüche

1. Elektronische Vorrichtung (300), die umfasst:
- ein Front-End-Modul (330), das umfasst:
• mindestens einen Front-End-Verbinder (352), der dafür ausgelegt ist, mit einem Kabel außerhalb der elektronischen Vorrichtung verbunden zu werden, um mindestens ein Funkfrequenzsignal zu empfangen und um Gleichstrom zu senden,
• ein Empfangsmodul (332), das dafür ausgelegt ist, das mindestens ein Funkfrequenzsignal von dem Front-End-Verbinder (352) zu empfangen;
- ein Abstimm- und Demodulationsmodul (334), das dafür ausgelegt ist, das mindestens eine Funkfrequenzsignal von dem Empfangsmodul zu empfangen; und das mindestens eine Funkfrequenzsignal in mindestens ein Transportstromsignal umzuwandeln,
- ein Schnittstellenmodul (320, 322, 324, 326), das mindestens ein Trennmodul umfasst, das dafür ausgelegt ist, das Front-End-Modul und ein Back-End-Modul (310) der elektronischen Vorrichtung galvanisch zu trennen und mindestens ein von dem Front-End-Modul (330) empfangenes digitales Signal an das Back-End-Modul (310) der elektronischen Vorrichtung zu senden;
wobei das Schnittstellenmodul mindestens ein getrenntes Gleichstromversorgungsmodul umfasst, das dafür ausgelegt ist, mit dem Back-End-Modul verbunden zu werden und Gleichstrom an mindestens ein Steuermodul des Front-End-Moduls zu senden,
- wobei das Back-End-Modul eine Steuerungsverarbeitungseinheit (312) umfasst, die dafür ausgelegt ist, mindestens ein Befehlssignal an das Steuermodul (336) des Front-End-Moduls (330) zu senden, wobei die Steuerungsverarbeitungseinheit dafür ausgelegt ist, als Reaktion auf das Befehlssignal in einer ersten Betriebsart, in der das Steuermodul (336) des Front-End-Moduls (330) dem Front-End-Verbinder (352) Gleichstrom zuführt, und als Reaktion auf das Befehlssignal in einer zweiten Betriebsart, in der dem Front-End-Verbinder (352) durch das Steuermodul (336) des Front-End-Moduls (330) kein Gleichstrom zugeführt wird, zu arbeiten;
wobei das durch das Abstimm- und Demodulationsmodul (334) ausgegebene Transportstromsignal durch das Modul (320, 326) für galvanische Trennung für die Steuerungsverarbeitungseinheit bereitgestellt wird.

2. Elektronische Vorrichtung (300) nach Anspruch 1, wobei die Steuerungsverarbeitungseinheit (312) dafür ausgelegt ist, über eine Benutzerschnittstelle der elektronischen Vorrichtung zwischen der ersten Betriebsart und der zweiten Betriebsart oder umgekehrt gewechselt zu werden.

3. Elektronische Vorrichtung (300) nach Anspruch 1 oder 2, wobei das Trennungsmodul dafür ausgelegt ist, einen Gleichstromsignaldurchgang und/oder eine Verbindung der Erde des Front-End- und des Back-End-Moduls zu verhindern.

4. Elektronische Vorrichtung (300) nach einem der Ansprüche 1 bis 3, wobei:
- das Back-End-Modul mindestens ein Back-End-Verbindungsmodul umfasst, das dafür ausgelegt ist, Gleichstrom von einer Gleichstromleitung zu empfangen; und
- das Schnittstellenmodul mindestens ein getrenntes Gleichstromversorgungsmodul umfasst, das dafür ausgelegt ist, mit dem Back-End-Verbindungsmodul verbunden zu werden und Gleichstrom an das Steuermodul (336) zu senden.

5. Elektronische Vorrichtung (300) nach einem der Ansprüche 1 bis 4, wobei das Steuermodul dafür ausgelegt ist, mindestens ein Steuersignal an den Front-End-Verbinder (352) zu senden.

6. Elektronische Vorrichtung (300) nach einem der Ansprüche 1 bis 5, wobei die Benutzerschnittstelle einen Schalter umfasst, der dafür ausgelegt ist, dem Steuermodul über die Steuerungsverarbeitungseinheit (312) Befehle zu geben.

7. Elektronische Vorrichtung (300) nach Anspruch 6, wobei mindestens teilweise auf den Schalter von einem Außengehäuse der elektronischen Vorrichtung zugegriffen werden kann.

8. Elektronische Vorrichtung (300) nach Anspruch 6 oder 7, wobei der Schalter dafür ausgelegt ist, manuell betätigt zu werden.

9. Elektronische Vorrichtung (300) nach einem der Ansprüche 1 bis 8, wobei die elektronische Vorrichtung einen persistenten Speicher umfasst, der dafür ausgelegt ist zu speichern, ob die Steuerungsverarbeitungseinheit (312) in der ersten Betriebsart oder in der zweiten Betriebsart ist.

## Revendications

1. Dispositif électronique (300) comprenant :
- un module frontal (330) comprenant :
• au moins un connecteur frontal (352) adapté pour être connecté à un câble externe audit dispositif électronique pour recevoir au moins un signal radiofréquence et pour transmettre un courant continu,
• un module de réception (332) adapté pour recevoir ledit au moins un signal radiofréquence dudit connecteur frontal (352) ;
- un module de syntonisation et de démodulation (334) adapté pour recevoir ledit au moins un signal radiofréquence dudit module de réception ; et pour transformer ledit au moins un signal radiofréquence en au moins un signal de flux de transport ;
- un module d'interface (320, 322, 324, 326) comprenant au moins un module d'isolation adapté pour isoler galvaniquement ledit module frontal et un module dorsal (310) dudit dispositif électronique, et pour transmettre, audit module dorsal (310) dudit dispositif électronique, au moins un signal numérique reçu dudit module frontal (330) ;
ledit module d'interface comprenant au moins un module d'alimentation en courant continu isolé, adapté pour être connecté audit module dorsal et pour transmettre un courant continu à au moins un module de contrôle dudit module frontal,
- ledit module dorsal comprenant une unité centrale de traitement (312) adaptée pour transmettre au moins un signal de commande audit module de contrôle (336) dudit module frontal (330), ladite unité centrale de traitement étant adaptée pour fonctionner dans un premier mode, où ledit module de contrôle (336) dudit module frontal (330) fournit un courant continu audit connecteur frontal (352) en réponse audit signal de commande, et dans un deuxième mode, où aucun courant continu n'est fourni par ledit module de contrôle (336) dudit module frontal (330) audit connecteur frontal (352) en réponse audit signal de commande ;
ledit signal de flux de transport généré par ledit module de syntonisation et de démodulation (334) est fourni par l'intermédiaire dudit module d'isolation galvanique (320, 326) à ladite unité centrale de traitement.

2. Dispositif électronique (300) selon la revendication 1, dans lequel ladite unité centrale de traitement (312) est adaptée pour être commutée entre ledit premier mode et ledit deuxième mode, ou inversement, par l'intermédiaire d'une interface utilisateur dudit dispositif électronique.

3. Dispositif électronique (300) selon la revendication 1 ou 2, dans lequel ledit module d'isolation est adapté pour empêcher une continuité d'un signal de courant continu et/ou une connexion à la terre desdits modules frontal et dorsal.

4. Dispositif électronique (300) selon l'une quelconque des revendications 1 à 3, dans lequel :
- ledit module dorsal comprend au moins un module de connexion dorsal adapté pour recevoir un courant continu d'une ligne de courant continu ; et
- ledit module d'interface comprend au moins un module d'alimentation en courant continu isolé, adapté pour être connecté audit module de connexion dorsal et pour transmettre un courant continu audit module de contrôle (336).

5. Dispositif électronique (300) selon l'une quelconque des revendications 1 à 4, dans lequel ledit module de contrôle est adapté pour transmettre au moins un signal de contrôle audit connecteur frontal (352).

6. Dispositif électronique (300) selon l'une quelconque des revendications 1 à 5, dans lequel ladite interface utilisateur comprend un commutateur adapté pour commander ledit module de contrôle par l'intermédiaire de ladite unité centrale de traitement (312).

7. Dispositif électronique (300) selon la revendication 6, dans lequel ledit commutateur est accessible au moins partiellement depuis un boîtier externe du dispositif électronique.

8. Dispositif électronique (300) selon la revendication 6 ou 7, dans lequel ledit commutateur est adapté pour être actionné manuellement.

9. Dispositif électronique (300) selon l'une quelconque des revendications 1 à 8 dans lequel ledit dispositif électronique comprend une mémoire persistante adaptée pour mémoriser si ladite unité centrale de traitement (312) est dans ledit premier mode ou ledit deuxième mode.
